# EUROPÄISCHE PATENTSCHRIFT

(11) **EP 1 703 559 B1**
(45) Veröffentlichungstag und Bekanntmachung des Hinweises auf die Patenterteilung: **29.06.2011**
(21) Anmeldenummer: 06004793.3
(22) Anmeldetag: 09.03.2006
(51) Int. Cl.: H01L 27/02, H02H 9/04

(54) **ESD Schutzschaltung für niedrige Spannungen**
Low voltage ESD protection circuit
Circuit de protection ESD à baisse tension

(30) Priorität: 18.03.2005 DE 102005013687
(43) Veröffentlichungstag der Anmeldung: 20.09.2006
(73) Patentinhaber: Atmel Automotive GmbH, 74072 Heilbronn (DE)
(72) Erfinder: Grombach, Peter, Dipl.-Ing., 74074 Heilbronn (DE); Klaussner, Manfred, Dipl.-Ing. (FH), 74080 Heilbronn (DE)
(74) Vertreter: Grünecker, Kinkeldey, Stockmair & Schwanhäusser Anwaltssozietät

(56) Entgegenhaltungen:
- US-A- 5 946 177
- US-A1- 2004 109 270
- US-B1- 6 452 768
- US-B1- 6 501 632

## Beschreibung

Die Erfindung betrifft eine ESD-Schutzschaltung mit einem ersten Feldeffekttransistor, der einen ersten Drainanschluss, einen ersten Sourceanschluss und einen ersten Steueranschluss (Gate) aufweist, und mit einem Eingangsnetzwerk.

Eine solche ESD-Schutzschaltung für niedrige Spannungen ist per se bekannt. Bei einer zwischen dem ersten Drainanschluss und dem ersten Sourceanschluss liegenden ersten Spannung, die einen Schwellenwert durchläuft, ändert das Eingangsnetzwerk eine zweite Spannung, die sich zwischen dem ersten Steueranschluss und dem ersten Sourceanschluss einstellt.

Bei der Handhabung und dem Einsatz Integrierter Schaltkreise (IC) ist es erforderlich, die darin enthaltenen Bauelemente und Baugruppen vor der Einwirkung von Überspannungen zu schützen. Als Überspannungen sind dabei elektrische Signale zu verstehen, wie sie beispielsweise bei einer Entladung statischer Aufladung, sei es von Menschen oder Maschinenteilen über einen IC bzw. eines IC über Menschen oder Maschinenteile, auftreten. Solche Entladungsvorgänge werden auch als electrostatic discharge (ESD) bezeichnet. Wirken solche Entladungsvorgänge auf einen Integrierten Schaltkreis ein, können irreversible Veränderungen an dessen Bauelementen oder Baugruppen erfolgen, z.B. durch Durchbrennen von Dünnschichten (thin film burn-out), Filamentierung (filamentation) und Kurzschließen von Schichtübergängen (junction spiking), Ladungsträgerinjektion in Oxidschichten oder Zerreißen von Oxidschichten (charge injection bzw. oxide rupture), was unter Umständen zu einer Zerstörung des gesamten IC führt. Unter niedrigen Spannungen werden in diesem Zusammenhang Betriebsspannungen für ICs in einer Größenordnung kleiner als 10 Volt verstanden.

Bei der per se bekannten ESD-Schutzschaltung besteht das Eingangsnetzwerk aus zwei Zenerdioden und einem Ohm'schen Widerstand. Die zwei Zenerdioden liegen in Reihe miteinander und als Reihenschaltung parallel zur ersten Spannung, also parallel zum Kanal des ersten Feldeffekttransistors. Der Widerstand liegt zwischen einer Verbindung des ersten Steueranschlusses mit einem Mittelabgriff der Reihenschaltung und dem ersten Sourceanschluss.

Zur Ableitung eines vorgegebenen ESD-Stroms, beziehungsweise einer vorgegebenen Leistung in Form eines Produktes aus ESD-Strom und ESD-Spannung, muss der erste Feldeffekttransistor eine vergleichsweise große Kanalfläche besitzen. Bei dem allgemeinen Trend zur Erhöhung der Packungsdichte Integrierter Schaltungen ist ein großer Flächenbedarf der ESD-Schutzschaltung grundsätzlich störend.

Aus US 5 946 177 ist eine ESD-Schutzschaltung bekannt, bei der das Eingangsnetzwerk einen zum ersten Feldeffekttransistor komplementären zweiten Feldeffekttransistor mit einem zweiten Drainanschluss, einem zweiten Sourceanschluss und einem zweiten Steueranschluss aufweist. Der erste Drainanschluss ist hierbei mit dem zweiten Sourceanschluss, über einen ersten Widerstand mit dem zweiten Steueranschluss sowie über den ersten Widerstand und eine erste Kapazität mit dem ersten Sourceanschluss verbunden. Der zweite Drainanschluss ist mit dem ersten Steueranschluss und über eine Parallelschaltung eines zweiten Widerstandes und einer zweiten Kapazität mit dem ersten Sourceanschluss verbunden. Der zweite Feldeffekttransistor bildet hierbei mit dem ersten Widerstand und der ersten Kapazität eine RC-Auslöseschaltung, während der zweite Widerstand und die zweite Kapazität eine RC-Verzögerungsschaltung darstellen. Die RC-Auslöseschaltung treibt den ersten Feldeffekttransistor nur während einer ihrer RC-Zeitkonstante entsprechenden anfänglichen Zeitspanne eines ESD-Ereignisses, während die RC-Verzögerungsschaltung anschließend den ersten Feldeffekttransistor entsprechend ihrer RC-Zeitkonstante im leitenden Zustand hält.

Nachteilig ist hierbei, daß insbesondere die als Kondensator ausgebildete erste Kapazität einen relativ großen Flächenbedarf aufweist. Nachteilig ist weiterhin, daß diese ESD-Schutzschaltung keinen Schutz vor unerwartet lange andauernden ESD-Ereignissen und unerwartet langsam ansteigenden, aber

Vor diesem Hintergrund besteht die Aufgabe der Erfindung in der Angabe einer ESD-Schutzschaltung, die zur Ableitung der genannten ESD-Größen Strom und/oder Leistung weniger Fläche benötigt.

Diese Aufgabe wird gelöst durch die Merkmale des Patentanspruchs 1.

Durch diese Merkmale kann die Potentialdifferenz zwischen dem ersten Steueranschluss und dem ersten Sourceanschluss bei einem ESD-Ereignis nahezu den Wert der Spannung am ersten Drainanschluss annehmen. Als Folge wird die sich dabei einstellende zweite Spannung (Gate-Sourcespannung) zwischen dem ersten Steueranschluss und dem ersten Sourceanschluss maximal, so dass der erste Feldeffekttransistor voll ausgesteuert wird.

Bei der per se bekannten ESD-Schutzschaltung unterscheidet sich das Potential, das sich bei einem ESD-Ereignis am ersten Steueranschluss einstellt, dagegen immer um den Wert der Durchbruchspannung einer der Zenerdioden von dem Potential am ersten Drainanschluss, was die sich dabei einstellende Gate-Source-Spannung beschränkt und damit zu einem vergleichsweise großen, auf die Kanalfläche normierten Innenwiderstand des ersten Feldeffekttransistors führt. Um dies zu kompensieren, muss das Produkt aus Kanalweite und Kanallänge des ersten Feldeffekttransistors größer sein als bei der Erfindung. Umgekehrt bedeutet dies, dass die erfindungsgemäße ESD-Schutzschaltung zur Ableitung einer vorgegebenen ESD-Leistung weniger Kanalfläche benötigt.

Die Zenerdiode stellt gewissermaßen den Schwellenwert bereit, bei dem die ESD-Schutzschaltung zwischen einem aktiven und einem inaktiven Zustand umschaltet. Damit wird die Grundanforderung an die ESD-Schutzschaltung, nämlich bei regulären Betriebsspannungen keine Störung der zu schützenden Schaltung darzustellen und nur bei Überspannungen Ströme aufzunehmen, erfüllt.

Im Rahmen einer Ausgestaltung der Erfindung ist bevorzugt, dass der zweite Feldeffekttransistor eine kleinere Kanalfläche besitzt als der erste Feldeffekttransistor, um den Flächenbedarf der ESD-Schutzschaltung klein zu halten.

Ferner ist bevorzugt, dass der zweite Feldeffekttransistor und die Zenerdiode so aneinander angepasst sind, dass die Gate-Source-Kapazität des zweiten Feldeffekttransistors der Sperrschichtkapazität der Zenerdiode entspricht.

Durch diese Merkmale wird das Zeitverhalten der ESD-Schutzschaltung optimiert, weil die bei einem ESD-Ereignis zur Umladung der Gate-Kapazität benötigte Ladung praktisch verzögerungslos von der Sperrschichtkapazität der Zenerdiode bereitgestellt wird. Als erwünschte Folge geht die ESD-Schutzschaltung bei einem ESD-Ereignis schnell in einen niederohmigen Zustand über.

Bevorzugt ist auch, dass zwischen der Zenerdiode und dem ersten Sourceanschluss ein dritter Widerstand angeordnet ist.

Die über diesen dritten Widerstand bei durchbrechender Zenerdiode abfallende Spannung reduziert die Spannung zwischen einem Gateoxid des Steueranschlusses und einem Drainanschluss des zweiten Feldeffekttransistors und verringert damit die Gefahr einer Beschädigung dieses Gateoxides bei einem ESD-Ereignis.

Der erste Feldeffekttransistor kann entweder ein N-Kanal-Enhancement Feldeffekttransistor oder ein P-Kanal-Enhancement Feldeffekttransistor sein.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: die per se bekannte ESD-Schutzschaltung zusammen mit einer zu schützenden Schaltung;
- Fig. 2: einen zeitlichen Verlauf der Spannung zwischen Steueranschluss und Sourceanschluss des ersten Feldeffekttransistors der Schaltung nach Fig. 1 bei einem rampenförmigen Anstieg der Spannung an dessen Drainanschluss;
- Fig. 3: eine Ausgestaltung einer erfindungsgemäßen ESD-Schutzschaltung mit einem N-Kanal-Feldeffekttransistor als erstem Feldeffekttransistor;
- Fig. 4: einen zeitlichen Verlauf der Spannung zwischen Steueranschluss und Sourceanschluss des ersten Feldeffekttransistors der Schaltung nach Fig. 3 bei einem rampenförmigen Anstieg der Spannung an dessen Drainanschluss; und
- Fig. 5: eine Ausgestaltung einer erfindungsgemäßen ESD-Schutzschaltung mit einem P-Kanal-Feldeffekttransistor als erstem Feldeffekttransistor.

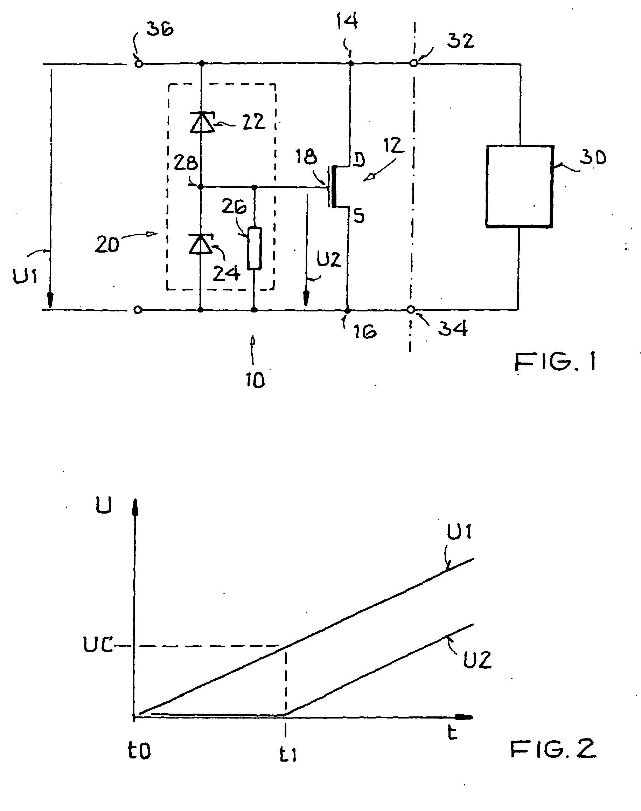

Im Einzelnen zeigt die Fig. 1 eine ESD-Schutzschaltung 10 mit einem ersten Feldeffekttransistor 12, der einen ersten Drainanschluss 14, einen ersten Sourceanschluss 16 und einen ersten Steueranschluss (Gate) 18 aufweist. Drainanschlüsse (Sourceanschlüsse) des ersten Feldeffekttransistors sind in den Figuren zusätzlich mit D (S) bezeichnet. Über dem ersten Feldeffekttransistor 12 liegt eine Spannung U1 an. Wenn die Spannung U1 bei einem ESD-Ereignis einen Schwellenwert durchläuft, ändert ein Eingangsnetzwerk 20 eine zweite Spannung U2, die sich zwischen dem ersten Steueranschluss 18 und dem ersten Sourceanschluss 16 einstellt.

Wie bereits eingangs erwähnt, besteht das Eingangsnetzwerk 20 bei der per se bekannten ESD-Schutzschaltung aus einer Reihenschaltung aus zwei Zenerdioden 22, 24 und einem Ohm'schen Widerstand 26, der an einen Mittelabgriff 28 der Reihenschaltung angeschlossen ist. Die Reihenschaltung liegt antiparallel zur ersten Spannung U1 und damit parallel zum Kanal des ersten Feldeffekttransistors 12 und der Widerstand 26 ist zusätzlich an den ersten Steueranschluss 18 und den ersten Sourceanschluss 16 angeschlossen.

Sofern die erste Spannung U1 kleiner als eine Durchbruchspannung UC der Zenerdiode 22 ist, fließt über den Widerstand 26 kein Strom, so dass sich am ersten Steueranschluss 18 das Potential des ersten Sourceanschlusses 16 einstellt. Der hier als N-Kanal-Feldeffekttransistor realisierte erste Feldeffekttransistor 12 sperrt in diesem regulären Fall, in dem eine zu schützende Schaltung 30, die zwischen Ausgängen 32, 34 der ESD-Schutzschaltung 10 liegt, mit der Spannung U1 betrieben wird.

Steigt die Spannung U1 dagegen durch eine positive Entladung am Eingang 36 der ESD-Schutzschaltung 10 über die Durchbruchspannung UC der Zenerdiode 22 an, bricht die obere Zenerdiode 22 durch, so dass sich an dem ersten Steueranschluss 18 ein Potential U1 - UC einstellt. Der erste Feldeffekttransistor 12 wird dann in einen leitfähigen Zustand gesteuert und leitet den positiven Entladestrom an der zu schützenden Schaltung 30 vorbei zu einem Bezugspotential ab. Die Leitfähigkeit des ersten Feldeffekttransistors 12 steigt dabei mit steigender Potentialdifferenz zwischen dem ersten Steueranschluss 18 und dem ersten Sourceanschluss 16. Diese Potentialdifferenz ist aber auf den genannten Wert U1 - UC beschränkt, so dass der erste Feldeffekttransistor 12 nie maximal, d.h. nie mit dem vollen Wert der Drain-Source-Spannung U1, ausgesteuert wird.

Dies wird durch die Fig. 2 verdeutlicht, die einen rampenförmigen Anstieg der Spannung U1 über der Zeit t und einen sich als Folge einstellenden Verlauf der Spannung U2 zeigt. Dabei ist für das Potential am ersten Sourceanschluss 16 der Wert Null angenommen worden. Dieser Wert greift zwischen t0 und t1 auf den ersten Steueranschluss 18 durch, so dass U2 in diesem Zeitraum gleich Null ist. Zum Zeitpunkt t1 durchläuft U1 den Wert UC, der die Durchbruchspannung der Zenerdiode 22 markiert. Für Zeiten t > t1 ergibt sich dann die Spannung U2 zu U1- UC, so dass U2 nie den Wert der Drainspannung U1 erreicht.

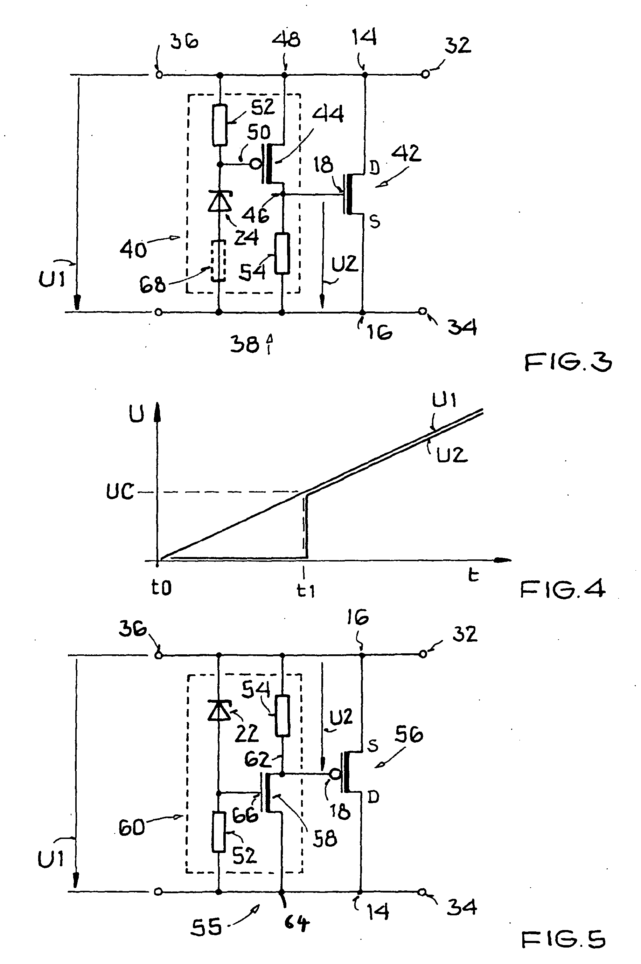

Fig. 3 zeigt eine Ausgestaltung einer erfindungsgemäßen ESD-Schutzschaltung 38, die sich zunächst durch ein geändertes Eingangsnetzwerk 40 von der bekannten ESD-Schutzschaltung 10 unterscheidet. Ein erster Feldeffekttransistor 42 ist in der Fig. 3 als N-Kanal-Feldeffekttransistor realisiert und mit einem eigenen Bezugszeichen bezeichnet, da er sich bei gleicher ESD-Leistung durch eine kleinere Kanalfläche von dem ersten Feldeffekttransistor 12 der Fig. unterscheidet. Ansonsten bezeichnen gleiche Bezugszeichen wie in der Fig. 1 zumindest funktionsmäßig gleiche Elemente. Das Eingangsnetzwerk 40 weist einen zu dem ersten Feldeffekttransistor 42 komplementären zweiten Feldeffekttransistor 44, also einen P-Kanal-Feldeffekttransistor auf, der einen zweiten Drainanschluss 46, einen zweiten Sourceanschluss 48 und einen zweiten Steueranschluss 50 besitzt. Der erste Drainanschluss 14 ist mit dem zweiten Sourceanschluss 48 und über einen ersten Widerstand 52 mit dem zweiten Steueranschluss 50 verbunden. Der zweite Drainanschluss 46 ist mit dem ersten Steueranschluss 18 und über einen zweiten Widerstand 54 mit dem ersten Sourceanschluss 16 verbunden.

Durch diese Änderungen ergibt sich eine Funktion, wie sie im Folgenden unter Bezug auf die Fig. 4 erläutert wird, die das Verhalten der Spannung U2 bei einem rampenförmigen Anstieg der Drainspannung U1 für den Gegenstand der Fig. 3 zeigt. Solange U1 kleiner als die Durchbruchspannung der Zenerdiode 24 ist, fließt (ggf. bis auf einen vemachlässigbaren Sperrstrom) kein Strom über den Widerstand 52, so dass sich am zweiten Steueranschluss 50 das Potential U 1 einstellt. Zwischen zweitem Sourceanschluss 48 und zweitem Steueranschluss 50 existiert daher höchstens ein vemachlässigbarer Potentialunterschied, so dass der zweite Feldeffekttransistor 44 sperrt. Dann fließt auch kein Strom über den zweiten Widerstand 54 und am ersten Steueranschluss 18 des ersten Feldeffekttransistors 42 stellt sich das Potential des Sourceanschlusses 16 ein, das auch hier, zum Zweck der Veranschaulichung, den Wert Null besitzen soll, ohne die Erfindung dadurch auf bestimmte Spannungswerte zu beschränken. Zwischen erstem Sourceanschluss 16 und erstem Steueranschluss 18 ergibt sich dann ebenfalls keine Potentialdifferenz, so dass auch der erste Feldeffekttransistor 42 sperrt.

Erst wenn zum Zeitpunkt t1, zu dem U1 die Durchbruchspannung UC der Zenerdiode 24 erreicht, ein Durchbruch stattfindet, greift die um den Wert der Durchbruchspannung verminderte Spannung U1, also die Spannung U1-UC, auf den Steueranschluss 50 durch, so dass der zweite Feldeffekttransistor 44, der vom P-Kanal-Typ ist, als Folge der damit entstehenden Potentialdifferenz zwischen zweitem Sourceanschluss 48 und zweitem Steueranschluss 50 in einen niederohmigen Zustand geschaltet wird. Als Folge greift die Spannung U1 nahezu unvermindert auf den ersten Steueranschluss 18 durch, so dass die Spannung U2 nahezu auf den Wert von U1 anwächst. Mit anderen Worten: Der erste Feldeffekttransistor 42 wird im Gegensatz zum ersten Feldeffekttransistor 12 voll ausgesteuert und kann daher einen entsprechend größeren ESD-Strom ableiten. Dadurch, dass die als Folge der stärkeren Aussteuerung erhöhte Stromleitfähigkeit bereits beim Schaltungsentwurf berücksichtigt wird, kann der erste Feldeffekttransistor 42 einen gleichen ESD-Strom wie der erste Feldeffekttransistor 12 mit einer verringerten Kanalfläche ableiten.

Gleiches gilt für die alternative Ausgestaltung einer ESD-Schutzschaltung 55 nach der Fig. 5, die mit einem P-Kanal-Feldeffekttransistor als erstem Feldeffekttransistor 56 zur Ableitung eines ESD-Stroms und einem N-Kanal-Feldeffekttransistor als zweitem Feldeffekttransistor 58 in der Eingangsschaltung 60 arbeitet. Die Anordnung des ersten Drainanschlusses 14 und des ersten Sourceanschlusses 16 ist bei dem Wechsel von N-Kanal zu P-Kanal angepasst worden. Gleiches gilt für den Abgriff der Spannung U2. Der zweite N-Kanal-Feldeffekttransistor 58 weist einen zweiten Drainanschluss 62, einen zweiten Sourceanschluss 64 und einen zweiten Steueranschluss 66 auf, wobei der erste Drainanschluss 14 mit dem zweiten Sourceanschluss 64 und über einen ersten Widerstand 52 mit dem zweiten Steueranschluss 66 verbunden ist. Der zweite Drainanschluss 62 ist mit dem ersten Steueranschluss 18 und über einen zweiten Widerstand 54 mit dem ersten Sourceanschluss 16 verbunden.

Die ESD-Schutzschaltung 55 der Fig. 5 zeigt ebenfalls das in der Fig. 4 dargestellte Verhalten: Solange U1 kleiner als die Durchbruchspannung der Zenerdiode 24 ist, fließt (ggf. bis auf einen vernachlässigbaren Sperrstrom) kein Strom über den Widerstand 52, so dass sich am zweiten Steueranschluss 66 das wieder zu Null angenommene Potential des ersten Sourceanschlusses 64 einstellt. Zwischen zweitem Sourceanschluss 64 und zweitem Steueranschluss 66 existiert daher höchstens ein vemachlässigbarer Potentialunterschied, so dass der zweite Feldeffekttransistor 58 sperrt. Dann fließt auch kein Strom über den zweiten Widerstand 54 und am ersten Steueranschluss 18 des ersten Feldeffekttransistors 56 stellt sich das Potential U1 ein. Zwischen erstem Sourceanschluss 16 und erstem Steueranschluss 18 ergibt sich dann ebenfalls keine Potentialdifferenz, so dass auch der erste Feldeffekttransistor 56 sperrt.

Erst wenn zum Zeitpunkt t1, zu dem U1 die Durchbruchspannung UC der Zenerdiode 24 erreicht, ein Durchbruch stattfindet, greift die um den Wert der Durchbruchspannung verminderte Spannung U1, also die Spannung U1 - UC, auf den zweiten Steueranschluss 66 durch, so dass der zweite Feldeffekttransistor 58, der vom N-Kanal-Typ ist, als Folge der damit entstehenden Potentialdifferenz zwischen zweitem Sourceanschluss 64 und zweitem Steueranschluss 66 in einen niederohmigen Zustand geschaltet wird. Als Folge stellt sich am ersten Steueranschluss 18 nahezu der Wert Null als Potential ein, so dass die Spannung U2 nahezu auf den Wert von U1 anwächst. Mit anderen Worten: Auch hier wird der erste Feldeffekttransistor 56 im Gegensatz zum ersten Feldeffekttransistor 12 voll ausgesteuert und kann daher einen entsprechend größeren ESD-Strom ableiten.

Bei den Ausgestaltungen der Figuren 3 und 5 kann optional zwischen der Zenerdiode 24 und dem ersten Sourceanschluss 16 ein dritter Widerstand 68 angeordnet sein, wie er in der Fig. 3 gestrichelt dargestellt ist.

## Patentansprüche

1. ESD-Schutzschaltung (38) mit einem ersten Feldeffekttransistor (42), der einen ersten Drainanschluss (14), einen ersten Sourceanschluss (16) und einen ersten Steueranschluss (18) aufweist, und mit einem Eingangsnetzwerk (40), das einen zu dem ersten Feldeffekttransistor (42) komplementären zweiten Feldeffekttransistor (44) mit einem zweiten Drainanschluss (46), einem zweiten Sourceanschluss (48) und einem zweiten Steueranschluss (50) aufweist, wobei der erste Drainanschluss (14) mit dem zweiten Sourceanschluss (48) und über einen ersten Widerstand (52) mit dem zweiten Steueranschluss (50) verbunden ist, und der zweite Drainanschluss (46) mit dem ersten Steueranschluss (18) und über einen zweiten Widerstand (54) mit dem ersten Sourceanschluss (16) verbunden ist, **dadurch gekennzeichnet, daß**
- das Eingangsnetzwerk (40) ausgestaltet ist, bei einer zwischen dem ersten Drainanschluss (14) und dem ersten Sourceanschluss (16) liegenden ersten Spannung (U1), die einen Schwellenwert durchläuft, eine zweite Spannung (U2) zu ändern, die sich zwischen dem ersten Steueranschluss (18) und dem ersten Sourceanschluss (16) einstellt, und
- der zweite Steueranschluss (50) über eine Zenerdiode (24) mit dem ersten Sourceanschluss (16) verbunden ist.

2. ESD-Schutzschaltung (38) nach Anspruch 1, **dadurch gekennzeichnet, dass** der zweite Feldeffekttransistor (44) eine kleinere Kanalfläche besitzt als der erste Feldeffekttransistor (42).

3. ESD-Schutzschaltung (38) nach Anspruch 1 oder 2, **dadurch gekennzeichnet, dass** der zweite Feldeffekttransistor (44) und die Zenerdiode (24) so aneinander angepasst sind, dass eine Gate-Source-Kapazität des zweiten Feldeffekttransistors (44) einer Sperrschichtkapazität der Zenerdiode (24) entspricht.

4. ESD-Schutzschaltung (38) nach wenigstens einem der vorhergehenden Ansprüche, **dadurch gekennzeichnet, dass** zwischen der Zenerdiode (24) und dem ersten Sourceanschluss (16) ein dritter Widerstand (68) angeordnet ist.

5. ESD-Schutzschaltung (38) nach wenigstens einem der vorhergehenden Ansprüche, **dadurch gekennzeichnet, dass** der erste Feldeffekttransistor ein N-Kanal-Enhancement Feldeffekttransistor (42) ist.

6. ESD-Schutzschaltung (55) nach wenigstens einem der Ansprüche 1 bis 4, **dadurch gekennzeichnet, dass** der erste Feldeffekttransistor ein P-Kanal-Enhancement Feldeffekttransistor ist (56).

## Claims

1. Electrostatic discharge protection circuit (38) with a first field effect transistor (42), which has a first drain terminal (14), a first source terminal (16) and a first control terminal (18), and with an input network (40), which comprises a second field effect transistor (44), which is complementary with the first field effect transistor (42), with a second drain terminal (46), a second source terminal (48) and a second control terminal (50), wherein the first drain terminal (15) is connected with the second source terminal (48) and by way of a first resistance (52) with the second control terminal (50), and the second drain terminal (46) is connected with the first control terminal (18) and by way of a second resistance (54) with the first source terminal (16), **characterised in that**
- the input network (40) is arranged to vary a second voltage (U2), which arises between first control terminal (18) and the first source terminal (16) when a first voltage (U1) lying between the first drain terminal (14) and the first source terminal (16) passes a threshold value, and
- the second control terminal (50) is connected with the first source terminal (16) by way of a Zener diode (24).

2. Electrostatic discharge protection circuit (38) according to claim 1, **characterised in that** the second field effect transistor (44) has a smaller channel area than the first field effect transistor (42).

3. Electrostatic discharge protection circuit (38) according to claim 1 or 2, **characterised in that** the second field effect transistor (44) and the Zener diode (24) are so matched to one another that a gate source capacitance of the second field effect transistor (44) corresponds with a blocking layer capacitance of the Zener diode (24).

4. Electrostatic discharge protection circuit (38) according to at least one of the preceding claims, **characterised in that** a third resistance (68) is arranged between the Zener diode (24) and the first source terminal (16).

5. Electrostatic discharge protection circuit (38) according to at least one of the preceding claims, **characterised in that** the first field effect transistor is an N-channel enhancement field effect transistor (42).

6. Electrostatic discharge protection circuit (38) according to at least one of claims 1 to 4, **characterised in that** the first field effect transistor is a P-channel enhancement field effect transistor (56).

## Revendications

1. Circuit de protection ESD (38) comprenant un premier transistor à effet de champ (42) qui présente une première électrode drain (14), une première électrode source (16) et une première électrode de commande (18) et comprenant un réseau d'entrée (40) qui présente un deuxième transistor à effet de champ (44) complémentaire au premier transistor à effet de champ (42) avec une deuxième électrode drain (46), une deuxième électrode source (48) et une deuxième électrode de commande (50), dans lequel la première électrode drain (14) est reliée à la deuxième électrode source (48) et à travers une première résistance (52) à la deuxième électrode de commande (50), et la deuxième électrode de drain (46) est reliée à la première électrode de commande (18) et à travers une deuxième résistance (54) à la première électrode source (16) **caractérisé en ce que**
- le réseau d'entrée (40) est configuré par une première tension (U1) entre la première électrode drain (14) et la première électrode source (16) qui dépasse une valeur de seuil, pour modifier une deuxième tension (U2) qui s'établit entre la première électrode de commande (18) et la première électrode source (16) et
- la deuxième électrode de commande (50) est reliée à la première électrode source (16) à travers une diode Zener.

2. Circuit de protection ESD (38) selon la revendication 1 **caractérisé en ce que** le deuxième transistor à effet de champ (44) possède une surface de canal inférieure au premier transistor à effet de champ (42).

3. Circuit de protection ESD (38) selon la revendication 1 ou 2 **caractérisé en ce que** le deuxième transistor à effet de champ (44) et la diode Zener (24) sont associés l'un à l'autre de façon qu'une capacité porte-source du deuxième transistor à effet de champ (44) corresponde à une capacité de jonction de la diode Zener (24).

4. Circuit de protection ESD (38) selon l'une au moins des revendications précédentes **caractérisé en ce qu'**entre la diode Zener (24) et la première électrode source (16) est prévue une troisième résistance (68).

5. Circuit de protection ESD (38) selon l'une au moins des revendications précédentes **caractérisé en ce que** le premier transistor à effet de champ est un transistor à effet de champ (42) à canal N renforcé.

6. Circuit de protection ESD (55) selon l'une au moins des revendications précédentes de 1 à 4 **caractérisé en ce que** le premier transistor à effet de champ est un transistor à effet de champ (56) à canal P renforcé.
